# EUROPEAN PATENT APPLICATION

(11) **EP 4 671 729 A1**
(43) Date of publication of application: **31.12.2025**
(21) Application number: 25185277.8
(22) Date of filing: 25.06.2025
(51) Int. Cl.: G01N 1/28, G01N 1/42

(54) **LAMELLA PREPARATION FROM THICK HPF SAMPLES**

(30) Priority: 26.06.2024 US 202463664390 P
(71) Applicant: FEI Company, Hillsboro, OR 97124-5793 (US)
(72) Inventor: SPURNY, Radovan, 627 00 Brno (CZ); MITCHELS, John, 627 00 Brno (CZ); KELLEY, Ronald, Hillsboro, 97124 (US); KOTECHA, Abhay, 5651 GG Eindhoven (NL); KARIA, Dimple, 5651 GG Eindhoven (NL); ZHANG, Xianjun, 5651 GG Eindhoven (NL); KLUMPE, Sven, 5651 GG Eindhoven (NL)
(74) Representative: Boult Wade Tennant LLP

(57) **Abstract**

Techniques for preparing a sample are described. A method includes directing a beam of ions toward a first surface of a sample for a first exposure of the first surface. The sample can define the first surface and a second surface, opposing the first surface. The method can include rotating the sample through an angle, β, relative to a beam axis, B of the charged particle beam system, to orient the second surface to receive the beam of ions. The method can include directing the beam of ions toward the second surface of the sample. The method can include rotating the sample relative to the beam axis, B, to orient the first surface to receive the beam of ions. The method can also include directing the beam of ions toward the first surface of the sample for a second exposure of the first surface.

## Description

### CROSS REFERENCE TO RELATED APPLICATION

This application claims the benefit of the provisional patent application having the serial number U.S. 63/664,390, entitled "LAMELLA PREPARATION FROM THICK HPF SAMPLES" Filed June 26, 2024, the contents of which are incorporated herein by reference in their entirety.

### TECHNICAL FIELD

Embodiments of the present disclosure are directed to charged particle microscope systems, as well as algorithms and methods for their operation. In particular, some embodiments are directed toward techniques for preparing samples for interrogation in charged particle beam microscopes.

### BACKGROUND

Cryo-FIB/SEM combined with cryo-electron tomography (cryo-ET) has emerged from within the field of cryo-electron microscopy (cryo-EM) as the method for obtaining the highest resolution structural information of complex biological samples in-situ in native and non-native environments. However, challenges remain in conventional cryo-FIB/SEM workflows, including milling thick specimens with vitrification issues, specimens with preferred orientation, low-throughput when milling small and/or low concentration specimens, and specimens that distribute poorly across grid squares.

A general approach called the 'Waffle Method' has been developed, which leverages high-pressure freezing to address these challenges. While the waffle method mitigates some of these challenges, geometric constraints and other limitations, restrict the method to samples having a thickness of 30 micrometers or less. There is a need, therefore, for different sample preparation techniques addressed at the same challenges that are applicable to cryogenic samples having a thickness greater than about 30 micrometers.

### SUMMARY

The terms and expressions which have been employed are used as terms of description and not of limitation, and there is no intention in the use of such terms and expressions of excluding any equivalents of the features shown and described or portions thereof, but it is recognized that various modifications are possible within the scope of the claimed subject matter. Thus, it should be understood that although the present claimed subject matter has been specifically disclosed by embodiments and optional features, modification and variation of the concepts herein disclosed can be resorted to by those skilled in the art, and that such modifications and variations are considered to be within the scope of this disclosure as defined by the appended claims. For example, the preceding aspects and various embodiments can be combined with one or more other aspects and/or embodiments of the same or other aspects.

In a first aspect, a method of preparing a sample for interrogation by a charge particle beam system includes directing a beam of ions toward a first surface of a sample for a first exposure of the first surface. The sample can define the first surface and a second surface, opposing the first surface. The method can include rotating the sample through an angle, β, relative to a beam axis, B of the charged particle beam system, to orient the second surface to receive the beam of ions. The method can include directing the beam of ions toward the second surface of the sample. The method can include rotating the sample relative to the beam axis, B, to orient the first surface to receive the beam of ions. The method can also include directing the beam of ions toward the first surface of the sample for a second exposure of the first surface.

In some embodiments, the method further includes forming a trench in the first surface using the beam of ions. The trench can be a first trench. The method can further include forming a second trench in the second surface. The second trench can be substantially aligned with the first trench. The first trench and/or the second trench can be an angled trench, oriented at a nonzero angle relative to the first surface. The angled trench can be oriented at a nonzero angle relative to a normal vector of the first surface. The first trench can extend part-way through the sample. The second trench can extend through the sample.

In some embodiments, the angle, β, has a magnitude of about 180 degrees. The method can further include rotating the sample through an angle, α, relative to the beam axis, B, to orient the first surface to receive the beam of ions. The angle, α, has a magnitude from about 10 degrees to about 60 degrees. Directing the beam of ions toward the second surface can include orienting the second surface to receive the beam of ions at an angle, γ, relative to the second surface. Directing the beam of ions toward the second surface can define a facet, oriented substantially at the angle, γ, relative to the first surface.

In some embodiments, the method further includes depositing a protective layer over at least a portion of the facet. The protective layer can include a metal and/or a dielectric. The depositing the protective layer can include decomposing a precursor using the beam of ions. The sample can include a region of interest. The method can further include forming a fin from the facet, using the beam of ions and thinning the fin to form a lamella including at least a portion of the region of interest. The region of interest can be a first region of interest. The sample can include a second region of interest. The method can further include forming a first lamella from the fin including at least a portion of the first region of interest and forming a second lamella from the fin including at least a portion of the second region of interest.

In some embodiments, the method further includes forming a stress relief cut in the facet between the first region of interest and the second region of interest.

The sample can be a cryogenically frozen sample. The sample can include a biological material prepared by a high-pressure freezer (HPF) method.

The method can further include milling a first vertical trench, extending through the sample from the first surface to the second surface, the first vertical trench being substantially normal to the first surface. The method can further include milling a second vertical trench, extending through the sample from the first surface to the second surface, the second vertical trench being substantially normal to the first surface and/or substantially aligned with the first vertical trench. The first vertical trench and the second vertical trench can be formed on either side of a region of interest in the sample, from which a lamella is to be prepared.

In a second aspect, a charged particle beam system includes a source of charged particles. The system can include a sample stage, operably coupled with the charged particle beam column and configured to translate and/or rotate a cryogenically frozen sample. The sample can define a first surface and a second surface opposing the first surface. The system can also include control circuitry, operably coupled with the source of charged particles and with the sample stage one or more machine-readable storage media, operably coupled with the control circuitry. The media can store executable instructions that, when executed, cause the system to perform operations. The operations can include those of the methods of the first aspect in one or more embodiments.

In a third aspect, one or more machine-readable storage media store executable instructions that, when executed by a machine, cause the machine to perform operations including those of the methods of the first aspect in one or more embodiments and/or operations of the second aspect in one or more embodiments.

Further aspects of the invention are set out in the following numbered clauses:
CLAUSE 1. A charged particle beam system, comprising:
   a source of charged particles;
   a sample stage, operably coupled with the charged particle beam column and configured to translate and/or rotate a cryogenically frozen sample, the sample defining a first surface and a second surface, opposing the first surface; and
   control circuitry, operably coupled with the source of charged particles and with the sample stage; and
   one or more machine-readable storage media, operably coupled with the control circuitry, the media storing executable instructions that, when executed, cause the system to perform operations including:
      directing a beam of ions toward a first surface of the sample for a first exposure of the first surface;
      rotating the sample through an angle, β, relative to a beam axis, B of the charged particle beam system, to orient the second surface to receive the beam of ions;
      directing the beam of ions toward the second surface of the sample;
      rotating the sample relative to the beam axis, B, to orient the first surface to receive the beam of ions; and
      directing the beam of ions toward the first surface of the sample for a second exposure of the first surface.
CLAUSE 2. The system of clause 1, wherein the operations further comprise:
   forming a trench in the first surface using the beam of ions; and
   forming a second trench in the second surface using the beam of ions, the second trench being substantially aligned with the first trench.
CLAUSE 3. The system of clause 1, wherein the angle, β, has a magnitude of about 180 degrees.
CLAUSE 4. The system of clause 2, wherein the operations further comprise rotating the sample through an angle, α, relative to the beam axis, B, to orient the first surface to receive the beam of ions.
CLAUSE 5. The system of clause 4, wherein the first trench extends partway into the sample, and wherein the second trench extends through the sample.
CLAUSE 6. The system of clause 1, wherein directing the beam of ions toward the second surface comprises orienting the second surface to receive the beam of ions at an angle, γ, relative to the second surface, defining a facet oriented substantially at the angle, γ, relative to the first surface.
CLAUSE 7. The method of clause 6, wherein the sample includes a region of interest, the method further comprising:
   forming a fin from the facet, using the beam of ions directed toward the first surface; and
   thinning the fin to form a lamella including at least a portion of the region of interest, using the beam of ions directed toward the first surface.

### BRIEF DESCRIPTION OF THE SEVERAL VIEWS OF THE DRAWINGS

The foregoing aspects and many of the attendant advantages of the present disclosure will become more readily appreciated as the same become better understood by reference to the following detailed description, when taken in conjunction with the accompanying drawings.
FIG. 1 is a schematic diagram illustrating an example dual-beam system, in accordance with some embodiments of the present disclosure.
FIG. 2A is a perspective view of one embodiment of a multi-axis stage, in accordance with some embodiments of the present disclosure.
FIG. 2B is a perspective view of another embodiment of a multi-axis stage, in accordance with some embodiments of the present disclosure.
FIG. 3 is a schematic diagram of a thermal control system, in accordance with some embodiments of the present disclosure.
FIG. 4A is a schematic diagram illustrating the components of a vitrification holder, used as part of the process for preparing HPF samples, in accordance with some embodiments of the present disclosure.
FIG. 4B is a schematic diagram illustrating components for retaining a sample grid as part of the HPF process, in accordance with some embodiments of the present disclosure.
FIG. 5 is a schematic block flow diagram illustrating a process for preparing lamellae from relatively thick samples, in accordance some embodiments of the present disclosure.
FIG. 6 is a schematic diagram illustrating an example process for preparing a lamella from relatively thick samples, in accordance with some embodiments of the present disclosure.
FIGs. 7A-7B are schematic diagrams illustrating an example process for preparing one or more lamella from relatively thick samples, in accordance with some embodiments of the present disclosure.
FIG. 8 is a schematic diagram illustrating an arrangement of features for preparing multiple lamellae in a sample, in accordance with some embodiments of the present disclosure.
FIG. 9 is a schematic diagram illustrating a view of an upper surface of a sample prepared for milling of multiple lamellae, in accordance with some embodiments of the present disclosure.
FIG. 10 is a schematic diagram illustrating a view of an upper surface of a sample prepared for milling of multiple lamellae, in accordance with some embodiments of the present disclosure.
FIG. 11 is an electron micrograph depicting multiple lamellae prepared in accordance with the processes of the present disclosure, prepared using a scanning electron microscope to generate the secondary electron signal.
FIG. 12 is an electron micrograph depicting multiple lamellae prepared in accordance with the processes of the present disclosure, prepared using a focused ion beam to generate the secondary electron signal.

In the drawings, not all instances of an element are necessarily labeled to reduce clutter in the drawings where appropriate. The drawings are not necessarily to scale, emphasis instead being placed upon illustrating the principles being described.

### DETAILED DESCRIPTION

While illustrative embodiments have been illustrated and described, it will be appreciated that various changes can be made therein without departing from the spirit and scope of the disclosure. Embodiments of the present disclosure include systems, methods, algorithms, and non-transitory media storing computer-readable instructions for preparing a sample for interrogation in a charged particle beam system.

The following detailed description focuses on embodiments of focused ion beam (FIB) preparation of cryogenic samples prepared by the high pressure freezer (HPF) method, in the interest of preparing a lamella sample for interrogation in a transmission electron microscope (TEM) but it is contemplated that additional and/or alternative instrument systems, sample types, and preparation techniques can be improved through the use of the techniques described. In an illustrative example, the techniques described herein can be applied to multilayer semiconductor samples, as an approach to precisely isolate a specific layer within the sample, thereby enabling enhanced resolution in imaging and microanalysis. Further, the techniques described herein also improve known challenges in thick samples, such as specimens with preferred orientation, low-throughput when milling small and/or low concentration specimens, and specimens that distribute poorly across grid squares.

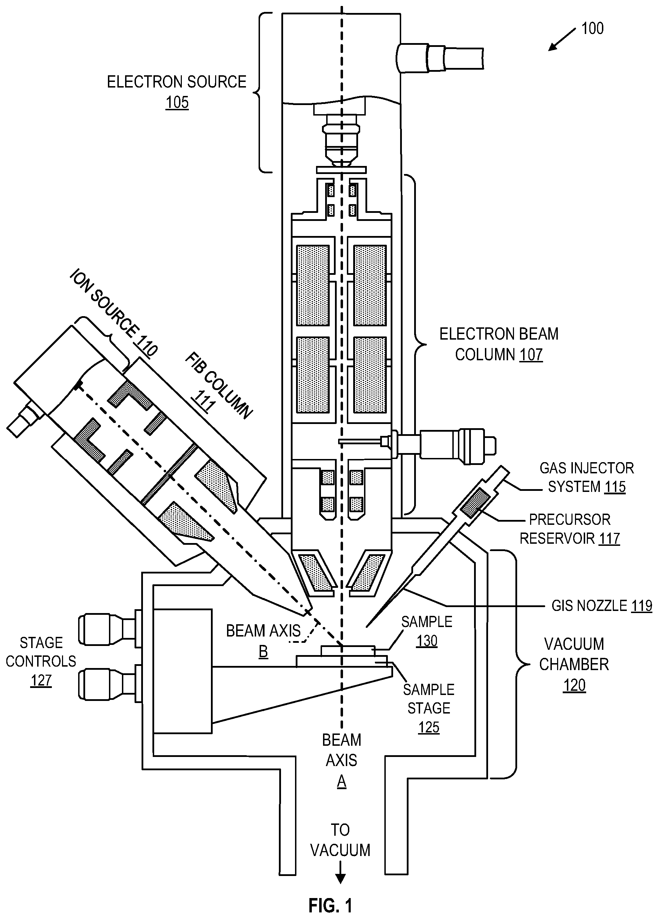

FIG. 1 is a schematic diagram illustrating an example dual-beam system 100, in accordance with some embodiments of the present disclosure. The example system 100 includes an electron source 105, an electron beam column 107, an ion source 110, a focused ion beam ("FIB") column 111, a gas injection system ("GIS") 115, a vacuum chamber 120, and a sample stage 125. The electron beam column 107 is illustrated as a scanning electron microscope (SEM) column, such that the example system 100 corresponds to a dual beam FIB-SEM system. The electron beam column 107, the FIB column 111, and the GIS 115 are illustrated as being operably coupled with the vacuum chamber 120, with the electron beam column 107 defining a first axis A and the FIB column 111 defining a second beam axis B. The axes A and B are illustrated converging onto a region of a sample 130, with the GIS 115 oriented toward the region of the sample 130 and configured to direct a gas stream including a precursor into the vacuum chamber. Advantageously, while axes A and B can also be oriented toward different locations, convergence permits the SEM system to image the region of the sample being processed by the FIB.

The electron source 105 can include one or more emitters configured to generate free electrons and to direct the electrons into the electron beam column 107. The emitters can include thermionic emitters, Schottky emitters, field-emission source emitters, or combinations thereof, operably coupled to power systems configured to apply a high-voltage (e.g., on the order of kilovolts to hundreds of kilovolts) to an emission region of the emitter material. For example, the electron source 105 can include a lanthanum hexaboride (LaB₆) emitter crystal to which a high electrical potential is applied to elicit the emission of electrons from a tip of the emitter crystal. In this way, a beam of electrons can be directed into the electron beam column 107.

The electron beam column 107 includes electromagnetic optics (e.g., electrostatic lenses, electromagnetic lenses, monochromators, aberration correctors, etc.) and apertures configured to shape, focus, defocus, narrow, and/or direct the beam of electrons such that the beam is focused onto the sample 130, in accordance with a set of operating parameters. The operating parameters can include a beam current, a beam energy (e.g., in volts, in electron volts, or the like), a magnification parameter, a scan pattern, a dwell time, and/or one or more pulse parameters. In this way, the example system 100 can function as an SEM to image portions of the sample 130 and/or can be used for e-beam assisted deposition of material onto the sample 130 (e.g., in coordination with the GIS 115) or other sample modifications.

The ion source 110 can include one or more components configured to generate a beam of ions and to direct the ions into the FIB column 111. In general, the ions can include metal ions and/or nonmetal ions (e.g., noble gas, halogen, oxygen, nitrogen, or the like). To that end, the ion source 110 can include a plasma source (e.g., an inductively coupled plasma source) and/or a metal ion source (e.g., a liquid-metal ion source). In the context of the present disclosure, atomic and/or molecular gases and their mixtures can serve as plasma precursor gases, from which a stream of ions can be extracted.

As with the electron beam column 107, the FIB column 111 can include electromagnetic optics (e.g., electrostatic lenses, electromagnetic lenses, monochromators, etc.) and apertures configured to shape, focus, defocus, narrow, and direct the beam of ions such that the beam is focused onto the sample 130, in accordance with a set of operating parameters. The operating parameters can include a beam current, a beam energy (e.g., in volts, in electron volts, or the like), a magnification parameter, a scan pattern, a dwell time, and/or one or more pulse parameters. In this way, the example system 100 can function as a FIB to modify portions of the sample 130 and/or to be used for ion-beam assisted removal of material from and/or deposition of material onto the sample 130 (e.g., in coordination with the GIS 115).

Analogous to the energies described in reference to the electron beam, above, the ion beam energy can be selected (e.g., by a user, by an algorithm initiated by a user, and/or automatically without user intervention). In some embodiments, additional and/or alternative precursor decomposition mechanisms (e.g., surface activation and/or secondary electron reemission) can be used as a mechanism for precursor decomposition, thereby allowing the ion beam energy to be determined based at least in part on a relationship between beam energy, sample material properties, and the energetic characteristics of the precursor deposition reaction mechanism. Advantageously, ion beam-induced deposition can elicit relatively high yields, in comparison to electron beam-induced deposition, based at least in part on the combined effect of multiple energy transfer pathways.

The GIS 115 includes constituent elements that together permit the GIS 115 to generate a gas stream including the precursor and to direct the gas stream into the vacuum chamber. The components of the GIS 115 can include a carrier gas inlet, a nozzle 119, and a conduit fluidically coupling the nozzle 119 and a precursor reservoir 117. The precursor reservoir 117 can include a substantially non-reactive container (e.g., a ceramic crucible, PTFE enclosure, a non-reactive metal or alloy, or the like) that is at least partially exposed to the conduit. In this way, vapor generated from a precursor disposed in the precursor reservoir 117 can be directed toward the nozzle and into the vacuum chamber (e.g., by pressure-driven flow induced by a pressure gradient relative to the vacuum of the vacuum chamber). In some embodiments, the GIS 115 includes a carrier gas inlet, fluidically coupled with the nozzle 119 via the conduit. In this way, the precursor can be entrained in a flow of carrier gas and directed toward the nozzle and into the vacuum chamber. Additionally and/or alternatively, the precursor can include a gas at standard conditions and can be introduced to the GIS 115 via a gas inlet provided as part of the GIS 115.

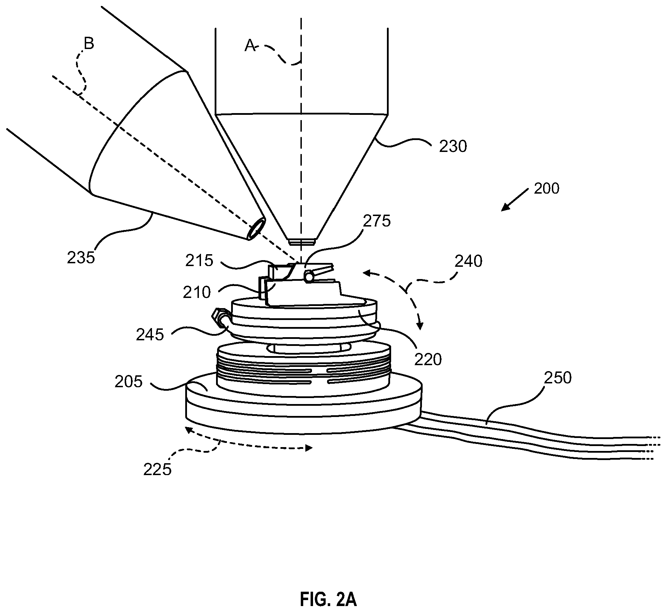

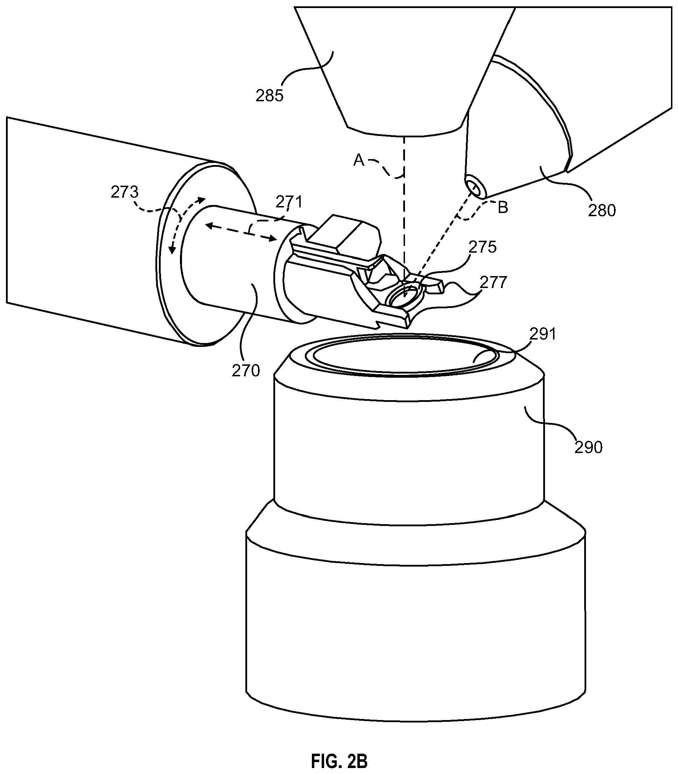

The operation of one or more components of the example system 100 can be coordinated by control circuitry, in accordance with machine-executable instructions (e.g., software, firmware, etc.) that can be stored in machine-readable storage media and/or received from external systems via wired and/or wireless communication techniques (e.g., over a WiFi or Bluetooth link). To that end, components of the example system 100 can be automated (e.g., operating without human intervention), pseudo-automated (e.g., operating with limited human intervention to initiate operations, analyze output and confirm, or the like), or manually operated (e.g., where individual operations of the example system 100 are performed and/or coordinated by a human user). In an illustrative example, the sample stage 125 can be mechanically coupled with automated stage controls 127 that permit the sample 130 to be reversibly tilted relative to the beam axes A and B, such that the surface of the sample is oriented at a particular angle relative to a given beam axis during operation of the corresponding charged particle beam source. In this way, the operation of a given beam source can be coordinated with the operation of the stage controls 127. Aspects of tilt-operation are described in more detail in reference to FIG. 2.

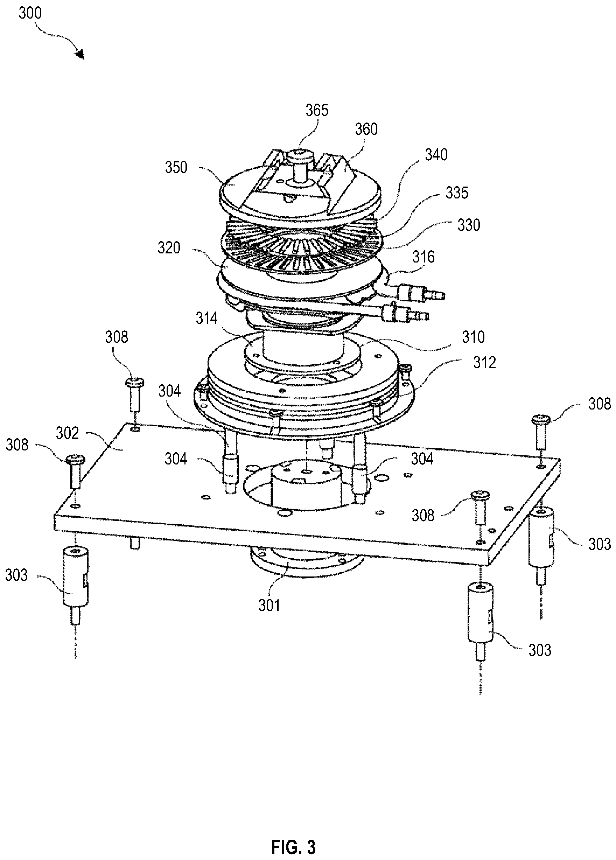

In some embodiments, the vacuum chamber 120 and/or other components of the example system 100 (e.g., sample stage 125, stage controls 127, etc.) can be configured for use with cryogenic samples. To that end, the sample stage 125 can include heat removal elements, such as a cooling loop, a high-thermal conductivity sample holder, and one or more modifications to the sample stage to facilitate introduction of a cryogenic sample into a vacuum environment. Aspects of cryogenic sample stage embodiments are described in more detail in reference to FIG. 3.

Some embodiments of the present disclosure omit one or more components of example system 100. For example, one or more of the sources 105 and 110 and/or columns 107 and 111 can be omitted. In an illustrative example, an single-beam FIB system can be configured to perform operations for generating a beam of ions. Similarly, a multi-beam FIB system other than a dual-beam FIB-SEM (e.g., a FIB-Laser system or a FIB-SEM system for which two or more beam axes are not convergently trained on a given region of the sample 130) can include the charged particle sources of the present disclosure.

FIG. 2A is a perspective view of one embodiment of a multi-axis stage 200, in accordance with some embodiments of the present disclosure. The multi-axis stage 200 includes a circular base 205 that supports a holder stand 210. Mounted on the stand 210 is a cryogenic sample holder 215. The cryogenic sample holder 215 is removably coupled with the stand 210 and configured to retain multiple sample grids (not shown), oriented at an angle relative to the circular base 205.

The circular base 205 includes a rotation actuator configured to rotate the holder 210 and a cooling element 220 with which it is coupled circumferentially about a first rotation axis 225. Thus, movement of the actuator results in rotational movement of the sample grids in the sample holder stand 210 with 360 degrees of movement about the base 205 of the multi-axis stage 200. This allows the sample to be rotated relative to the beam axes A and B of the electron beam source 230 and the ion beam source 235.

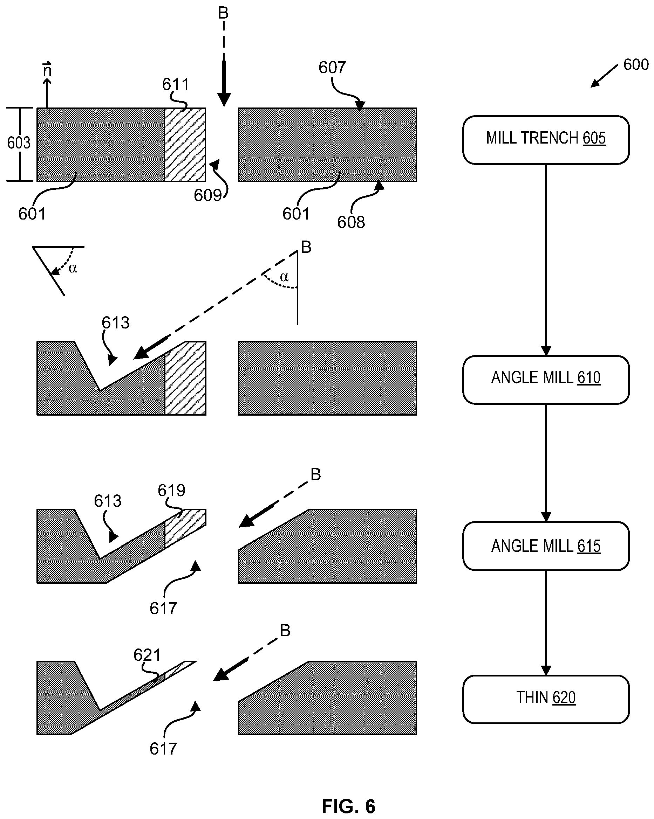

The stage 200 is mechanically coupled with stage motion actuators that enable a second rotation axis 240. The second rotation axis 240 can be aligned with a plane defined by the beam axes A and B, such that by a combination of rotations along the first rotation axis 225 and the second rotation axis 240, an arbitrary angle of incidence of a charged particle beam to upper or lower surfaces of the sample grids disposed in the holder 215 can be defined. As described in reference to the processes of FIGs. 6-7, the stage 200 can be oriented such that the beam axis B is oriented toward an underside of the sample grid or toward an upper surface of the sample grid, with an angle of incidence from about 0 degrees to about 90 degrees.

Cooling element 215 is provided with a liquid coolant via a conduit 245 that is in thermal contact with the cooling element 215. The liquid coolant can be or include liquified gases, such as liquid nitrogen, liquid helium, or the like, or can be or include chilled liquid coolants that are formulated to maintain a liquid phase at cryogenic temperatures. The liquid coolant is delivered to the cooling element 215 via a coolant loop 250 that is fed through the vacuum chamber of the charged particle beam system (e.g., system 100 of FIG. 1). Inlet and outlet lines of the coolant loop 250 are provided with enough slack to enable full range-of-motion of the stage 200.

FIG. 2B is a perspective view of another embodiment of a multi-axis stage 270, in accordance with some embodiments of the present disclosure. The multi-axis stage 270 is configured to operate as part of a multibeam cryogenic sample preparation system, which is an example of the multibeam system 100 of FIG. 1. The cryogenic sample preparation system of FIG. 2B includes a focused ion beam (FIB) source 280, an electron beam (SEM) source 285, and an optical source 290. The stage 270 is configured to translate along a first axis 271 and to rotate about a second axis 273. In this way, a sample 275 retained in the sample stage 270 can be oriented relative to the first beam axis A and the second beam axis B. The stage 270 includes components for maintaining the sample 275 at cryogenic conditions while under vacuum and/or irradiation by charged particles from the sources 280 and 285. For example, the stage 270 can include a relatively high thermal mass with the capacity to remove heat from the sample 275, either by including coolant and/or via a thermally conductive coupling with a reservoir of low temperature material (e.g., liquid nitrogen, liquid helium, or the like).

The stage 270 can be configured to hold the sample 275 using opposing adjustable grips, providing linear clearance down to a relatively low angle of incidence for second axis B on both an upper surface of the sample 275 and a lower surface of the sample 275, as described in more detail in reference to sample preparation processes of the present disclosure. In this way, the sample 275 can be rotated such that an ion beam and/or an electron beam can be incident on either side of the sample 275. The optical source 290 can be oriented to direct a beam and/or bright field of photons toward the sample 275. For example, the optical source 290 can include confocal optics 291 permitting the sample preparation process implemented using the sources 280 and 285 to be complemented with confocal imaging of biological structures in the sample 275.

FIG. 3 is a schematic diagram of a thermal control system 300, in accordance with some embodiments of the present disclosure. The thermal control system 300 can be used to heat or cool the multi-axis stage 200 of FIG. 2A, but still allow the stage 200 to move circularly within an imaging system. The thermal control system 300 includes a base 301 that mounts through a platform 302 via a series of connectors 304. A system of standoffs 303 may be used to raise the platform 302 to a desired level within the imaging system. The standoffs can be mounted to the platform 302 through a series of pins 308. FIG. 3 is reproduced from United States Patent US8754384B1.

As shown, the base 301 fits within a cylindrical sleeve 310 that mates into the center of a metal ring 312. Mated to a top surface 314 of the sleeve 310 is a heat transfer body 320 including a heat transfer pipe 316 that is configured to move a heat transfer medium. In one embodiment, the heat transfer medium is cooled dry or liquid nitrogen and the temperature of the heat transfer plate 320 can be controlled by controlling the flow rate of the dry nitrogen with a flow meter (not shown) or adding a supplemental heat source, such as a thermal resistor. Thus, by controlling the type and amount of heat transfer medium circulating through the head transfer pipe 316 (and/or controlling the extra heat source), the user can control the resulting temperature of the heat transfer plate 320. In some embodiments, the platform 302, standoffs 303, connectors 304, and pins 308, are omitted, with the metal ring 312 and other components being adapted to couple with stage motion components as described in reference to in FIG. 2A.

Above and in thermal contact with the heat transfer plate 320 is a bearing ring 330 that has a plurality of slots 335. Each of the slots 335 in the bearing ring 330 are configured to hold thermally conductive rollers 340. Above the rollers 340 is a top plate 350. The top plate 350 includes a mounting bracket 360 and centering pin 365 that are designed to mount with the multi-axis stage 200 and provide thermal heating or cooling functionality to the multi-axis stage 200. Top plate 350 can rotate around its axis driven via the base 301.

As can be envisioned, when a multi-axis stage is mounted into the mounting bracket 360, the stage can rotate in 360 degrees on top of the roller bearings (for example ball bearings or needle bearings) and still maintain thermal connectivity with the heat transfer medium that is flowing through the pipe 316. In this embodiment, all parts may be designed with a high thermal conductivity. For example, the roller bearings can be made of steel with a conductivity of 46 W/mK. The cold stage parts can be made of oxygen free copper, or other materials with a high thermal conductivity, for example, gold. In some embodiments, the temperature of the shuttle receiver can go down to -120° C., -130° C., -140° C., -150° C., -160° C., -170° C., -180° C. or less in temperature. In some embodiments, the device can be used to transfer heat such that the system is heated rather than cooled by pumping heated liquid or gas into the pipe 316.

It is noted that the stage can be equipped with one roller bearing offering the needed mechanical support and degree of freedom, while the stage further shows a second roller bearing thermally connecting the stage with a stationary cooling body, cooled by, for example, liquid nitrogen.

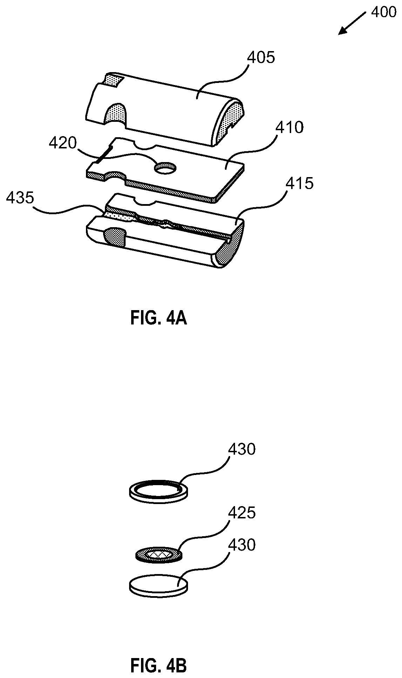

Embodiments of the present disclosure include a method of planar lamella preparation from relatively thick high-pressure freezer (HPF) samples. HPF preparation procedures include a vitrification process, components for which are illustrated in FIGs. 4A-4B. FIG. 4A is a schematic diagram illustrating the components of a vitrification holder 400, used as part of the process for preparing HPF samples. The holder 400 includes an upper half cylinder 405, a middle plate 410, and a lower half cylinder 415. The middle plate 410 defines an aperture 420 shaped to accept a sample grid 425, illustrated in FIG. 4B. The sample grid 425 can be disposed between two retaining elements 430, referred to as "planchette hats." The sample grid 425 can be cryogenically frozen at elevated pressure by assembling the holder 400 and placing the holder 400 in an anvil cell or other holder configured to apply a force to the upper half cylinder 405 and the lower half cylinder 415. One or more conduits 435 defined in the cylinder(s) 405 and 415 can introduce a coolant (e.g., liquid nitrogen) through the holder 400 while the sample grid 425 is pressurized, which can be cooled to cryogenic temperatures.

The so-called "waffle method" for lamella preparation, described by Kelley et al. *(*Kelley, Kotaro, et al. "Waffle Method: A general and flexible approach for improving throughput in FIB-milling. "Nature Communications 13.1 (2022): 1857*.)* is limited to thin HPF samples, having a characteristic thickness less than about 30 micrometers, above which lamellae typically exhibit "shadow lamella" artefacts in transmission electron microscopy. In this context, the term "shadow lamellae" refers to material remaining on a "backside" of the prepared lamella that is only visible during TEM acquisition (e.g., such material is invisible under in situ SEM imaging), which is only found after removing the sample to a TEM and makes the lamella ineffective as a cryo-electron tomography (cryo-ET) sample. The "backside" refers to the face of the sample that is not exposed to the incident ion beam, in contrast to a "front side" that is exposed to the incident ion beam.

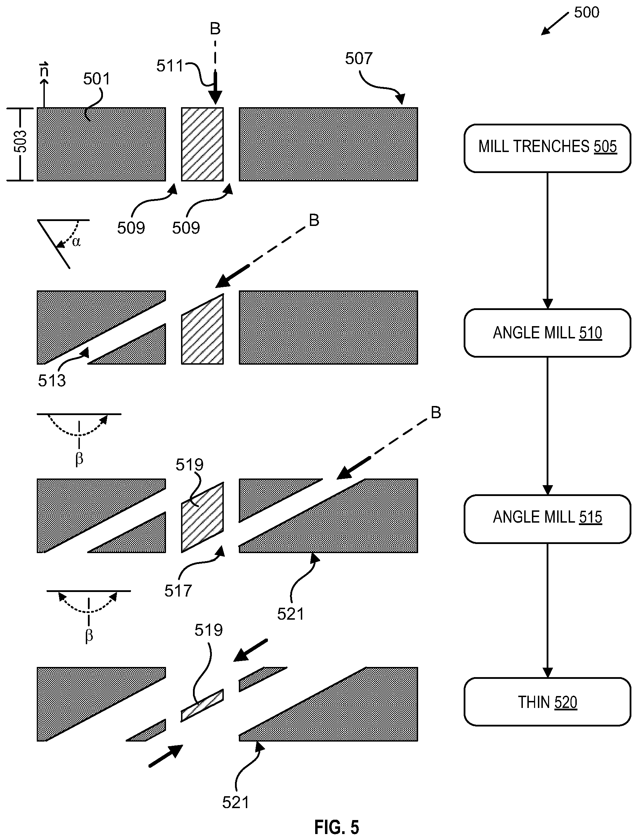

Addressed at such limitations, systems of the present disclosure (e.g., example system 100 of FIG. 1) can include sample stages (e.g., sample stage 200 of FIG. 2) with a tilt range from about 0 degrees to about 300 degrees, relative to a reference angle, including fractions, interpolations, and sub-ranges thereof. Advantageously, a wide tilt angle range allows for a dual-sided method for lamellae preparation from samples having a thickness greater than about 30 micrometers, including samples thicker than about 100 micrometers, as described in more detail in reference to FIGs. 5-7B. In this way, techniques of the present disclosure are suitable for relatively thick samples, having a thickness in the milling direction greater than about 30 micrometers.

FIG. 5 is a schematic block flow diagram illustrating a process 500 for preparing lamellae from relatively thick samples, in accordance some embodiments of the present disclosure. One or more operations of the example process 500 can be executed by a computer system in communication with additional systems including, but not limited to, charged particle beam systems, characterization systems, network infrastructure, databases, and user interface devices. For example, the systems can include the dual beam system 100 of FIG. 1 and/or the tilt stage 200 of FIGs. 2-3, as well as control circuitry configured to operate the systems. To that end, some operations of the example process 500 can be encoded in one or more machine-readable storage media electronically coupled with the control circuitry.In some embodiments, at least a subset of the operations described in reference to FIG. 5 are performed automatically (e.g., without human involvement) or pseudo-automatically (e.g., with human initiation or limited human intervention). In some embodiments, one or more operations of process 600 are omitted, reordered, and/or repeated. In some embodiments, one or more operations are added, as described in more detail in reference to FIGs. 6-12.

The process 500 improves on the waffle method described in *Kelley, et al.* by eliminating the limitation to relatively thin cryogenically frozen samples, below about 30 micrometers. As previously described, the waffle method produces shadow artefacts in lamella that limit their applicability to transmission electron microscopy. The process 500, in contrast, can be used to prepare a sample 501 having a thickness 503 less than about 30 micrometers, defined relative to an upper surface 507, as well as greater than 30 micrometers. The process 500 includes milling dual trenches 509 in the sample 501 using a beam of ions 511 at operation 505. The trenches 509 are oriented normal to the upper surface 507 and are formed through the thickness 503 of the sample. The trenches 509 further define the portion of the sample 501 that is subsequently thinned to exhibit transparency to energetic electrons. At operation 510, the process 500 includes orienting the sample 501 relative to the beam axis B by tilting the sample through an angle, α, relative to the beam axis, B, and milling a first angled trench 513 through one of the two trenches 509. At operation 515, the sample 501 is flipped relative to the beam axis B by tilting the sample through an angle, β, and a second angled trench 517 is formed through the sample 501. The two trenches 513 and 517 together define two opposing angled surfaces in a central portion 519 of the sample 501 from which the lamella will be defined at operation 520 by iterative thinning of the central portion 519.

The angle, β, can have a magnitude from about ninety degrees to about 270 degrees, including subranges, fractions, and interpolations thereof. In an illustrative example, the angle, β, can have a magnitude that permits a lower surface 521 of the sample 501 to be oriented face-on toward the beam of ions (e.g., the angle, β, can have a magnitude of about 180 degrees). In this way, thinning the central portion 519 can include repeatedly flipping the sample 501 and milling to widen the angled trenches 513 and 517 through the upper surface 511 and the lower surface 521, respectively.

In contrast to the waffle method, the process 500 produces lamella that do not exhibit the shadow artefacts for samples 501 having a thickness 503 greater than about 30 micrometers. Without being bound to a specific physical phenomenon or mechanism, the thickness limitation of the waffle method can be attributed at least in part to redeposition of milled material on internal surfaces of the angled trenches, such that a lower surface of the lamella formed from the central portion can include redeposited material from the sample. The process 500, unlike the waffle method, includes milling the second angled trench 517 from the lower surface 521. This approach reduces length of the path from the surface to the central portion 519, limiting the redeposition of sputtered sample material onto the underside of the central portion 519.

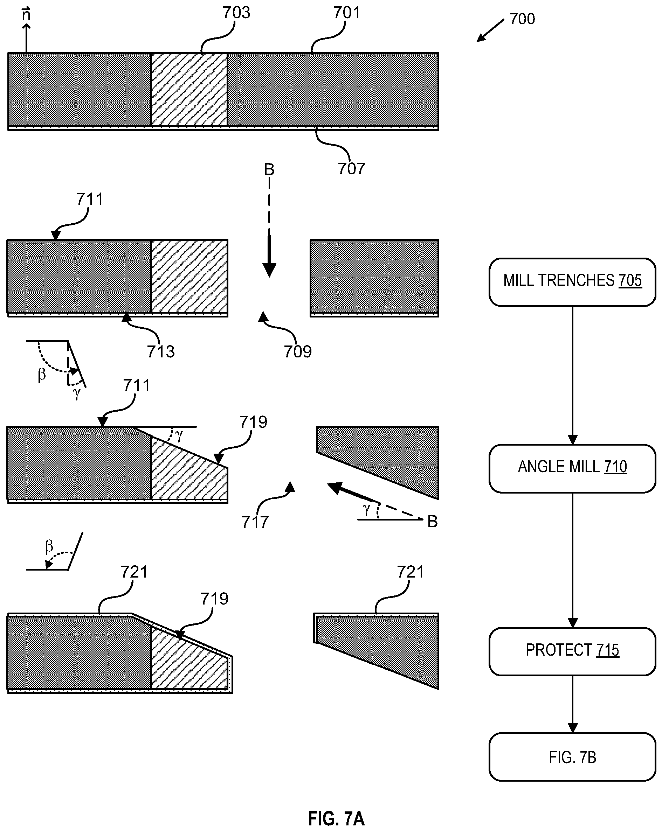

FIG. 6 is a schematic diagram illustrating an example process 600 for preparing a lamella from a relatively thick sample, in accordance with some embodiments of the present disclosure. One or more operations of the example process 600 can be executed by a computer system in communication with additional systems including, but not limited to, charged particle beam systems, characterization systems, network infrastructure, databases, and user interface devices. For example, the systems can include the dual beam system 100 of FIG. 1 and/or the tilt stage 200 of FIGs. 2-3, as well as control circuitry configured to operate the systems. To that end, some operations of the example process 600 can be encoded in one or more machine-readable storage media electronically coupled with the control circuitry. In some embodiments, at least a subset of the operations described in reference to FIG. 6 are performed automatically (e.g., without human involvement) or pseudo-automatically (e.g., with human initiation or limited human intervention). In some embodiments, one or more operations of process 600 are omitted, reordered, and/or repeated. In some embodiments, one or more operations are added, as described in more detail in reference to FIGs. 7A-12.

At operation 605, the example process 600 includes milling a vertical trench 609 at an angle that is substantially normal to the upper surface. In this context, the term "vertical" refers to a relative orientation in reference to the upper surface 607, rather than an absolute coordinate system. Alternatively, operation 605 can include milling the vertical trench 609 from the underside, via a lower surface 608. The vertical trench 609 is formed through the thickness 603 of the sample 601, and one wall of the vertical trench 609 defines a region of interest (ROI) 611 of the sample 601, from which the lamella will be formed. At operation 610, the sample 601 is oriented relative to the beam axis B and a first angled trench 613 is formed part-way through the thickness 603 of the sample 601. The first angled trench 613 is formed by milling sample material at the opposite side of the (ROI) 611, relative to the vertical trench 609. At operation 615, a second angled trench 617 is formed in the sample 601 at least in part by translating the sample 601 relative to the beam axis B and transecting the vertical trench 609. In contrast to process 500, operation 615 produces a fin portion 619 that is constrained on three sides rather than two sides, thereby reducing the extent of deformation in the sample. At operation 620, a lamella fin 621 is formed at least in part by widening the second angled trench 617, such that the ROI 619 will be at one end of the lamella fin 621 when it is removed from the sample 601.

Advantageously, the example process 600 can be used for samples having a characteristic thickness 603 that is less than 30 micrometers, but can also be used for thicker samples without exhibiting shadow artefacts in TEM analysis. This is due, at least in part, to the different approach to angled milling that eliminates the geometric constraints on milling the first and second angled trenches that are implicated in process 500 of the present art (e.g., the waffle method). In this way, Embodiments of the present disclosure enable preparation of lamellae from relatively thick HPF samples, which is not possible with conventional techniques. Advantageously, the methods described herein provide a valuable alternative to the lift-out method.

Embodiments of the present disclosure include a method for preparing lamella from a cryogenic sample using a plasma focused ion beam (PFIB) system configured to accept relatively thick frozen tissue or high-pressure frozen prepared samples. Conventional methods, such as plunge freezing of cells on a grid, are not application when larger sample volumes are used in biological studies (e.g., tissue samples). To improve sample quality, alternative techniques for cryogenic preparation are used, such as high pressure freezing (HPF), to promote vitreous freezing. HPF samples present a different sample geometry, characterized by a larger layer of continuous ice ~20-300 µm thick, that implicate a new lamella preparation strategy.

To that end, methods of the present disclosure include efficient, fast and reliable cryo-lamella preparation for HPF prepared samples, illustrated in the figure, above. Stage angular range constraints restrict usage of current approaches that include patterning only an upper surface of a sample. The methods of the present disclosure include an iterative milling approach that includes patterning the lower surface of the sample to form a facet in a vicinity of a region of interest in the sample, and iteratively directing the beam of ions to the upper surface of the sample at different positions and/or angles relative to the upper surface, to form a lamella including at least a portion of the region of interest.

This approach enables systems (e.g., a stage-constrained system) to process relatively thick samples (e.g., about 20 microns or more). Further, embodiments can include GIS deposition of a protective layer on the lower surface, which enables faster and better results. For example, the protective layer can mechanically support the sample during milling and can remove heat and reduce charge buildup. As illustrated above, the methods described herein permit internal structures to be included in lamellae, which is a significant challenge for a region of interest in a relatively thick tissue sample. For example, conventional approaches to lamella preparation in thick samples limit lamella location to a region near the upper surface of the sample. The instant approach, however, includes forming a facet that enables a lamella to be formed at locations throughout the volume of the sample.

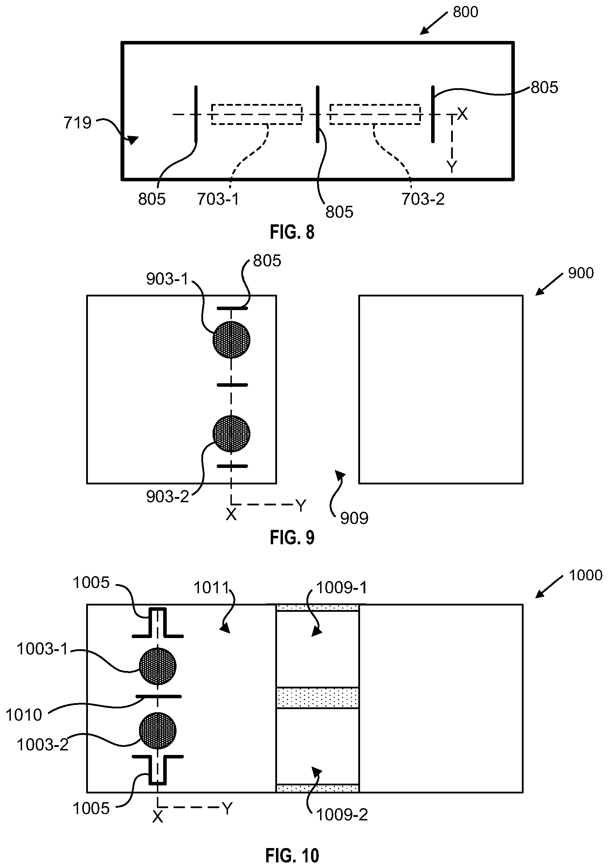

FIGs. 7A-7B are schematic diagrams illustrating an example process 700 for forming lamella from relatively thick samples, in accordance with some embodiments of the present disclosure. Example process 700 is an example of process 600, for which additional operations have been included to permit the lamella to be formed at an intermediate depth in the sample, corresponding, for example, to an internal structure of the sample. As with process 600, one or more operations of the example process 700 can be executed by a computer system in communication with additional systems including, but not limited to, charged particle beam systems, characterization systems, network infrastructure, databases, and user interface devices. For example, the systems can include the dual beam system 100 of FIG. 1 and/or the tilt stage 200 of FIGs. 2-3, as well as control circuitry configured to operate the systems. To that end, some operations of the example process 700 can be encoded in one or more machine-readable storage media electronically coupled with the control circuitry. In some embodiments, at least a subset of the operations described in reference to FIGs. 7A-7B are performed automatically (e.g., without human involvement) or pseudo-automatically (e.g., with human initiation or limited human intervention). In some embodiments, one or more operations of process 600 are omitted, reordered, and/or repeated. In some embodiments, one or more operations are added, as described in more detail in reference to FIGs. 8-12.

At operation 705, a vertical trench 709 is formed in a sample 701 that includes a region of interest (ROI) 703. The vertical trench 709 is oriented substantially normal to an upper surface 711 of the sample 701 and extends through a lower surface 713 of the sample. The sample 701 can include a protective layer 707 deposited over at least part of the lower surface 713. As in the case of process 600, the vertical trench 709 is formed on one side of the ROI 703. As described in reference to process 600 of FIG. 6, the operations of process 700 can include processing the sample via the lower surface 713, rather than proceeding via the upper surface 711.

At operation 710, the sample is reoriented (e.g., by one or more angular tilts of the sample holder and/or stage), such that the lower surface 713 is oriented toward the beam axis B and a first angled trench 717 is formed through the sample 701. The reorientation can include tilting the sample through an angle, β, defined relative to the upper surface 711 and/or the lower surface 713. The tilt angle is shown having a counter-clockwise, "negative," direction, but it can alternatively have a clockwise, "positive," direction, in some cases. The angle, β, can have a magnitude from about 90 degrees to about 270 degrees, including subranges, fractions, and interpolations thereof. The magnitude of the angle, β, can be based at least in part on an incident angle for the beam of ions (e.g., a relative orientation of the beam axis B to the lower surface 713) to be used in operation 710.

The first angled trench 717 transects the vertical trench 709 and further defines a facet 719 in the ROI 703. The facet 719 can be oriented at an angle, γ, relative to the plane of the upper surface. The angle, γ, can have an absolute value from about 0 degrees to about 90 degrees, including fractions, sub-ranges, and interpolations thereof. The angle, γ, can be defined in reference to the beam axis, B, such that the orientation of the sample 701 relative to the beam axis B, which can be defined by the motion of the stage and/or sample holder, can be used to define the geometry of the facet 719.

Operation 710 can include widening the first angled trench 717 through progressively milling into the ROI 703. In this way, the lamella defined in operation 725 can include a region of the ROI 703 at an arbitrary location. Widening the first angled trench 717 can include translating the sample 701 such that the angle, γ, relative to the plane of the upper surface is preserved and/or can include scanning the beam such that the angle defined by the facet is smaller than the angle γ. A smaller value of the angle, γ, provides an advantage of a thinner lamella after operation 720, but presents increased risk of deformation during processing.

At operation 715, process 700 includes forming a protective layer over at least a portion of the facet 719 and/or the upper surface 711. As illustrated, additional surfaces can be protected, as well. The entire surface of the facet 719 can be protected, as can the entire upper surface 711. Operation 715 can include reorienting the sample 701 such that the upper surface is substantially orthogonal to the beam axis B. The reorientation in operation 715 can include a tilt of the sample through an angle that returns the upper surface 711 to the face-on orientation and substantially normal to the beam axis B, either through the remainder of a full rotation (e.g., an angle equal to 2π-β) or in the reverse rotation direction through the angle, β.

Operation 715 can also include introducing a deposition precursor (e.g., an organometallic precursor, such as methyl cyclopentadienyl trimethyl platinum, a dielectric precursor, tetraethylorthosilicate, or the like) into the vicinity of the sample 701 and using the energy of a beam of ions to decompose the precursor onto the upper surface 711 and/or the facet 719.

At operation 720, process 700 includes reorienting the sample 701 and parallel angle milling of the facet 719 to form a fin 723. Reorienting the sample 701 can include tilting the sample through an angle, α, such that the upper surface 711 is oriented face-on relative to the incident ion beam. The angle, α, can have a magnitude from about zero degrees to about 90 degrees, including subranges, fractions, and interpolations thereof. In some embodiments, the angle, α, is defined as the complementary angle to the angle, β, used in operation 710. In this way, the facet 719 can be oriented face-on toward the beam of ions, with the surface of the facet 719 being substantially normal to the beam axis, B.

The angle, α, can be carefully chosen to reduce the prevalence and/or likelihood of a milling artefact referred to as a "shark fin" that results from vertical redeposition growth of sputtered sample material. Shark fin-type artefacts are relatively more likely to develop when milling at lower angles of incidence, based at least in part on the relatively higher probability of sample material being removed at a low angle relative to the surface being patterned. Advantageously, the patterning techniques described herein reduce or substantially eliminate such redeposition and limit the likelihood of resultant shark fin artefacts. Further, the double-lamella approach, illustrated below in electron micrographs and schematic diagrams, permits multiple lamellae to be formed in the sample in a side-by-side configuration, based at least in part on directing the beam of ions toward the facet 719 at different positions and repeating the operations of the processes of the present disclosure. Advantageously, the protocols of the present disclosure can be applied to a broad range of HPF tissue samples (e.g., samples prepared in an assembly without a planchette in various configurations).

The surface of the facet 719 can be oriented at an angle between about zero degrees and about 90 degrees, relative to the beam axis, B, including subranges, fractions, and interpolations thereof. In an illustrative example, the sample 701 can be oriented relative to the beam axis, B, such that the beam of ions is incident onto the facet 719 at an angle between zero degrees and α. Advantageously, a relatively low angle of incidence, compared to normal incidence, improves the quality of lamella produced by reducing heating and associated amorphization of the fin 723 during parallel milling.

Parallel milling in operation 720 can include translating the sample 701 relative to the beam axis, B, to iteratively mill the upper and lower surfaces of the fin 723. In some embodiments, the beam of ions is deflected to mill the upper and lower surfaces of the facet 719, additionally with or alternatively to moving the sample 701. In this way, the fin 723 can define a trapezoidal cross section. The fin 723 can be attached to the sample 701 material on three sides, in contrast to the process 500 described in reference to FIG. 5. In some embodiments, operation 720 includes patterning one or more stress relief features into the facet 719, as described in more detail in reference to FIG. 8-10.

At operation 725, the process 700 includes thinning the fin 723 to form a lamella 725 from the ROI 703. The lamella 725 can be thinned to the point that the material is substantially transparent to electrons having an average energy that is used in a transmission electron microscope. In this way, the sample 701 can be loaded into a charged particle microscope for additional microscopy and microanalysis, such as a TEM or other system. In some embodiments, thinning operations can be used for reconstruction of structures in the ROI 703. For example, the sample 703 can include cellular microstructures or other biological materials. Where the process 700 is performed using a multi-beam system, such as a dual-beam FIB-SEM, operations for electron microscopy and/or microanalysis can be included as part of lamella thinning.

In some embodiments, lamella yield is increased by implementing a double-lamella method. FIGs. 8-10 are schematic diagrams illustrating aspects of the double lamella method, in accordance with some embodiments of the present disclosure. The double lamella method includes patterning two or more lamellae in a side-by-side configuration, using one or more trenches offset from the region(s) of interest along a lateral axis, labeled X.

FIG. 8 is a schematic diagram illustrating an arrangement 800 of features 805, in accordance with some embodiments of the present disclosure. The features 805 are shown on the surface of the facet 719 and represent a portion of the surface from which material has been removed (e.g., a milled or etched portion). In this way, the process 700 can be modified to include multiple regions of interest 703, that can be substantially aligned along a lateral axis, X. The arrangement 800 includes a feature 805 on an outer side of a first ROI 703-1, a feature 805 between the first ROI 703-1 and a second ROI 703-2, and a feature on an outer side of the second ROI 703-2. The features 805 can be substantially orthogonal to the lateral axis, X, aligned with a second lateral axis, Y. The plane defined by the axes X and Y can be substantially coincident with the surface of the facet 719.

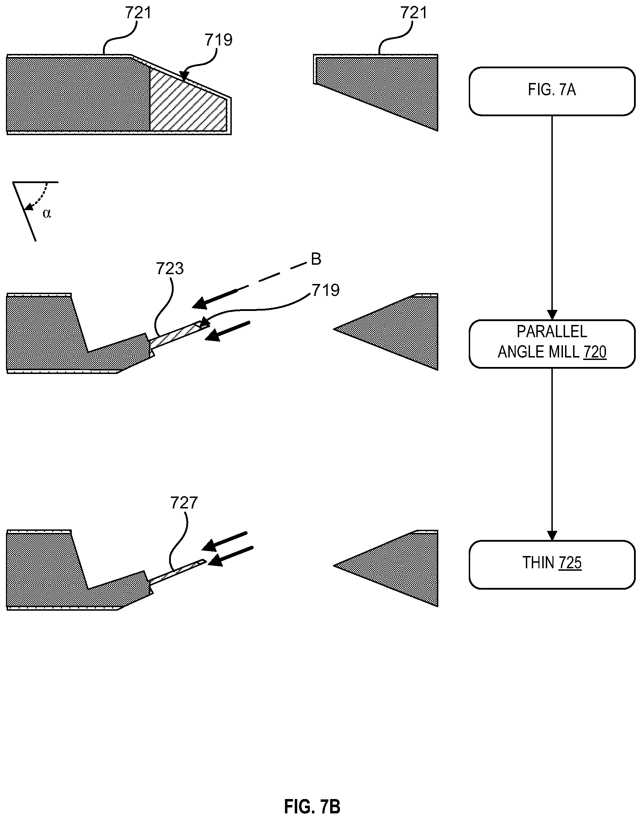

Advantageously, features 805, being formed into the surface of the facet 719, can alleviate internal stress in lamella that can deform as the fins (e.g., fin 723 of FIG. 7) are thinned to a thickness of substantial transparency to electrons. The features 805 can be linear, as shown, but can also define a geometry, such as a notch, a cross, a spot, or the like, an example of which is illustrated in FIG. 9. The linear design of the features 805 in the example arrangement 800 provide a functional advantage, however, over more complex geometries, in that the features 805 occupy less surface area, are less likely to induce failure in the region between the ROIs 703, and can be produced more simply, making their fabrication more suitable for automation.

FIG. 9 is a schematic diagram illustrating a view of an upper surface 911 of a sample 900 prepared for milling of multiple lamellae, in accordance with some embodiments of the present disclosure. The diagram includes a projection of the arrangement 800 onto the upper surface, prior to formation of the facet (e.g., facet 719 of FIG. 7 and FIG. 8) in accordance with the process 700 of FIG. 7. The sample 900 includes a single vertical trench 909 formed into the upper surface 911, through which the beam of ions can be directed to form the facet. The features 805 are formed into the facet as described in reference to FIG. 8.

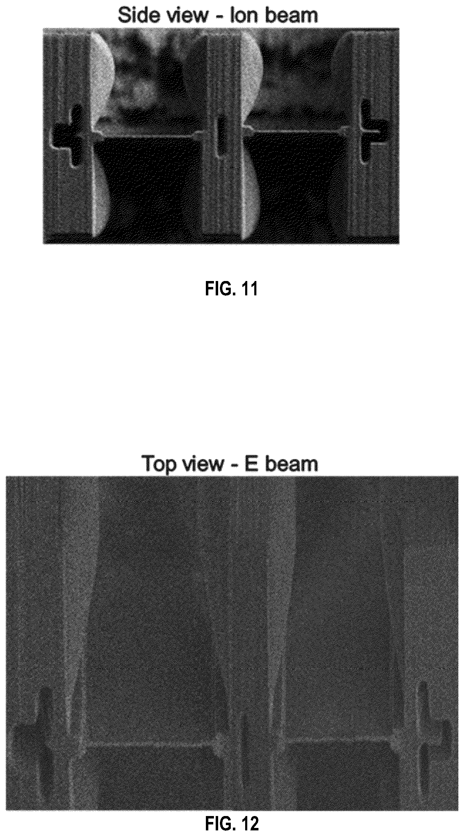

FIG. 10 is a schematic diagram illustrating a view of an upper surface 1011 of a sample 1000 prepared for milling of multiple lamellae, in accordance with some embodiments of the present disclosure. Similar to the diagram in FIG. 9, The diagram of FIG. 10 includes a projection of features 1005 and 1010 onto the upper surface 1011, prior to formation of the facet (e.g., facet 719 of FIG. 7 and FIG. 8) in accordance with the process 700 of FIG. 7. In contrast to the sample 900 of FIG. 9, the sample 1000 includes a first vertical trench 1009-1 and a second vertical trench 1009-2 formed into the surface 1011. The sample 1000 includes two regions of interest 1003. Two different types of features are defined in the surface 1011, two notch-type features 1005 are formed bracketing the ROIs 1003, and a stress-relief feature 1010 is formed between the first ROI 1003-1 and the second ROI 1003-2. Advantageously, the stress relief feature 1010 reduces the transmission of strain between the first ROI 1003-1 and the second ROI 1003-2, as the facet is milled and thinned down into two lamellae (e.g., lamella 727. The notch-type features 1005 are used to isolate lateral stresses in both X-Y directions, relieving internal strain, and reducing twisting motion and resultant periodic deformation (e.g., "wrinkling") in the lamellae, as illustrated in electron micrographs generated for an example side-by-side multi-lamella sample, prepared using the process 700 of FIG. 7, and using the arrangement of features 1005 and 1010 that are provided in FIGs. 11-12.

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While example embodiments described herein center on cryo-EM systems, and dual-beam Cryo-FIB systems in particular, these are meant as non-limiting, illustrative embodiments. Embodiments of the present disclosure are not limited to such embodiments, but rather are intended to address analytical instruments systems for which a wide array of material samples can be processed for further analysis to determine chemical, biological, physical, structural, or other properties, among other aspects, including but not limited to chemical structure, trace element composition, or the like, in a charged particle beam instrument.

Some embodiments of the present disclosure include a system including one or more data processors and/or logic circuits. In some embodiments, the system includes a non-transitory computer readable storage medium containing instructions which, when executed on the one or more data processors and/or logic circuits, cause the one or more data processors and/or logic circuits to perform part or all of one or more methods and/or part or all of one or more processes and workflows disclosed herein. Some embodiments of the present disclosure include a computer-program product tangibly embodied in non-transitory machine-readable storage media, including instructions configured to cause one or more data processors and/or logic circuits to perform part or all of one or more methods and/or part or all of one or more processes disclosed herein.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

Where terms are used without explicit definition, it is understood that the ordinary meaning of the word is intended, unless a term carries a special and/or specific meaning in the field of charged particle microscopy systems or other relevant fields. The terms "about" or "substantially" are used to indicate a deviation from the stated property within which the deviation has little to no influence of the corresponding function, property, or attribute of the structure being described. In an illustrated example, where a dimensional parameter is described as "substantially equal" to another dimensional parameter, the term "substantially" is intended to reflect that the two parameters being compared can be unequal within a tolerable limit, such as a fabrication tolerance or a confidence interval inherent to the operation of the system. Similarly, where a geometric parameter, such as an alignment or angular orientation, is described as "about" normal, "substantially" normal, or "substantially" parallel, the terms "about" or "substantially" are intended to reflect that the alignment or angular orientation can be different from the exact stated condition (e.g., not exactly normal) within a tolerable limit. For numerical values, such as diameters, lengths, widths, or the like, the term "about" can be understood to describe a deviation from the stated value of up to ±10%. For example, a dimension of "about 10 mm" can describe a dimension from 9 mm to 11 mm.

The description provides exemplary embodiments, and is not intended to limit the scope, applicability or configuration of the disclosure. Rather, the ensuing description of the exemplary embodiments will provide those skilled in the art with an enabling description for implementing various embodiments. It is understood that various changes may be made in the function and arrangement of elements without departing from the spirit and scope as set forth in the appended claims. Specific details are given in the description to provide a thorough understanding of the embodiments. However, it will be understood that the embodiments may be practiced without these specific details. For example, specific system components, systems, processes, and other elements of the present disclosure may be shown in schematic diagram form or omitted from illustrations in order not to obscure the embodiments in unnecessary detail. In other instances, well-known circuits, processes, components, structures, and/or techniques may be shown without unnecessary detail.

## Claims

1. A method of preparing a sample for interrogation by a charge particle beam system, the method comprising:
directing a beam of ions toward a first surface of a sample for a first exposure of the first surface, the sample defining the first surface and a second surface, opposing the first surface;
rotating the sample through an angle, β, relative to a beam axis, B of the charged particle beam system, to orient the second surface to receive the beam of ions;
directing the beam of ions toward the second surface of the sample;
rotating the sample relative to the beam axis, **B,** to orient the first surface to receive the beam of ions; and
directing the beam of ions toward the first surface of the sample for a second exposure of the first surface.

2. The method of claim 1, further comprising forming a trench in the first surface using the beam of ions.

3. The method of claim 2, wherein the trench is a first trench, the method further comprising forming a second trench in the second surface, the second trench being substantially aligned with the first trench.

4. The method of claim 1, claim 2 or claim 3, wherein the angle, β, has a magnitude of about 180 degrees.

5. The method of any preceding claim, further comprising rotating the sample through an angle, α, relative to the beam axis, B, to orient the first surface to receive the beam of ions.

6. The method of claim 5, wherein α has a magnitude from about 10 degrees to about 60 degrees.

7. The method of any preceding claim, wherein directing the beam of ions toward the second surface comprises orienting the second surface to receive the beam of ions at an angle, γ, relative to the second surface.

8. The method of claim 7, wherein directing the beam of ions toward the second surface defines a facet, oriented substantially at the angle, γ, relative to the first surface.

9. The method of claim 8, further comprising depositing a protective layer over at least a portion of the facet.

10. The method of claim 8, wherein the sample includes a region of interest, the method further comprising:
forming a fin from the facet, using the beam of ions; and
thinning the fin to form a lamella including at least a portion of the region of interest.

11. The method of claim 10, wherein the region of interest is a first region of interest, wherein the sample includes a second region of interest, and wherein the method further comprises:
forming a first lamella from the fin including at least a portion of the first region of interest; and
forming a second lamella from the fin including at least a portion of the second region of interest.

12. The method of claim 11, further comprising forming a stress relief cut in the facet between the first region of interest and the second region of interest.

13. The method of any preceding claim, wherein the sample is a biological material prepared by a high-pressure freezer (HPF) method.

14. A charged particle beam system, comprising:
a source of charged particles;
a sample stage, operably coupled with the charged particle beam column and configured to translate and/or rotate a cryogenically frozen sample, the sample defining a first surface and a second surface, opposing the first surface; and
control circuitry, operably coupled with the source of charged particles and with the sample stage; and
one or more machine-readable storage media, operably coupled with the control circuitry, the media storing executable instructions that, when executed, cause the system to carry out the method steps of any one of claims 1-14.
